(19) Europäisches Patentamt

European Patent Office

Office européen des brevets

(11) EP 0 795 631 A1

(12) EUROPEAN PATENT APPLICATION

(43) Date of publication:
17.09.1997 Bulletin 1997/38

(51) Int Cl.⁶: **C30B 15/00**

(21) Application number: 97200411.3

(22) Date of filing: 13.02.1997

(84) Designated Contracting States:
DE FR GB

(30) Priority: 23.02.1996 US 12307

(71) Applicant: **Saint-Gobain/Norton Industrial Ceramics Corporation Worcester, MA 01615-0138 (US)**

(72) Inventors:
• **Murphy, Harold J.
Aurora, Ohio 44202 (US)**
• **Novak, William P.
Middlefield, Ohio 44062 (US)**
• **Rybicki, Alan F.
Mentor, Ohio 44060 (US)**

(74) Representative: **Richebourg, Michel François Cabinet Michel Richebourg, "Le Clos du Golf", 69, rue Saint-Simon 42000 Saint Etienne (FR)**

(54) **Scintillation crystals having reduced afterglow and method of making the same**

(57) Methods of making a scintillation crystal having reduced afterglow include preparing a crystal melt according to the Czochralsky technique and doping the melt with an element or a compound which reduces afterglow without significantly reducing the luminescence light output of the crystal grown in the melt. Experiments have shown that doping the melt with any one of calcium, cobalt, germanium, niobium, sodium, and chromium significantly reduces afterglow without unduly reducing the luminescence light output of the crystal. The presently preferred dopant is cobalt, which is added to the melt in concentrations of approximately 10ppm to 50ppm. Crystals made according to the method of the invention exhibit significantly less afterglow than crystals made from the same raw materials without doping. By choice of the proper concentration of dopant, the light output of the crystal during luminescence is not adversely affected.

**Description**

This application claims the benefit of co-pending provisional application Serial No. 60/012,307, filed February 23, 1996.

BACKGROUND OF THE INVENTION

1. Field of the Invention

The invention relates to scintillation crystals used in radiation detectors. More particularly, the invention relates to scintillation crystals used to detect x-rays or gamma rays.

2. State of the Art

Computer-assisted, or computerized tomography is widely used in medicine and in other fields to non-invasively study the interior structure of the human body or some other object (such a as airline luggage, e.g.). A tomography scanner generally includes one or more sources of ionizing radiation, such as x-rays or gamma rays, and one or more radiation detectors. The detectors are typically arranged in banks of arrays with the total number of detectors in a scanner being in the hundreds or thousands. An object to be studied is placed between the radiation source and the detectors. The object is scanned by moving the detectors, the radiation source, or both relative to the object in selected planes while pulsing the radiation source. The output of the detectors is recorded over time and analyzed by a computer to produce a series of scans which, when properly integrated, can be used to form a three dimensional image of the internal structure of the object scanned.

There are many factors which affect the accuracy and safety of tomographic scanners. When scanning living subjects, it is desirable to minimize the amount of exposure to radiation in the interest of safety. In order to achieve high resolution images, it is desirable to pulse the radiation source on the order of one hundred times per second and record the output of the detectors at each pulse.

The radiation detectors used in tomographic scanners are constructed from a scintillator and a photo-electric sensor. The scintillator luminesces, or scintillates when bombarded with ionizing radiation and the photo-electric sensor converts the light output of the scintillator into an electrical signal. As an object is scanned, the interior structure of the object absorbs more or less of the radiation depending on the density and composition of the interior structure. The light output of the scintillator therefore varies as the object is scanned, and output of the photo-electric sensor is therefore related to the interior structure of the object being scanned.

There are two types of scintillators commonly used in computerized tomography - gas filled tubes and crystals. Crystals are preferred because they can be easily arranged in closely packed arrays.

Various materials are used to make scintillation crystals. The luminescent and physical characteristics of cadmium tungstate ($CdWO_4$) make it a good choice for use in radiation detectors. The crystals are cut into as small crystal rods with rectangular cross-sections and a photodetector is attached directly to one face of each crystal. Typically, a number of crystals with attached detectors are bonded together to form a detector array as described in U.S. Patents Number 4,694,177 and Number 4,725,734.

All scintillators, including cadmium tungstate crystals, have certain measurable characteristics, including light output, emission spectra, decay components, and afterglow. When excited by x-rays, Cadmium tungstate crystals emit light in the wavelength range of about 350 nm (nanometers) to 750 nm with a peak output at about 480 nm. The light output of the crystal depends largely on the its purity. Cadmium tungstate has two natural exponential decay components, one at approximately 1.1 microseconds and one at approximately 14 microseconds. That is, when x-ray excitation ceases, luminescence will halt in a matter of microseconds. All crystals will possess a certain amount of afterglow, which is detected as a very low level light output persisting beyond the time of natural decay. Afterglow in crystals usually decays exponentially and may continue for several seconds before the crystal is completely dark. In pulsed radiation tomography, afterglow causes significant degradation of the tomographic image. In particular, afterglow results in the creation of artifacts, or bright pixels which obscure the image. In order to avoid the effects of afterglow, a slower scanning rate may be used, but this reduces the overall resolution of images of living organs.

There is a need for the reduction or elimination of afterglow in certain scintillation materials.

SUMMARY OF THE INVENTION

In accordance with the present invention, which will be discussed in detail below, a crystal melt for growing a scintillation crystal according to the Czochralsky or any other technique is doped with an element or a compound which reduces afterglow without significantly reducing the luminescence light output of the crystal grown from the melt. Thus, the invention concerns the discovery that certain impurities which are introduced in the crystal melt in appropriate concentrations actually reduce afterglow. Experiments have shown that doping the melt with any one of cobalt, niobium, calcium, sodium, germanium, and chromium trioxide significantly reduce afterglow without unduly reducing the light output of the crystal. The presently preferred dopant is cobalt which is added to the melt in concentrations of about 50 ppm or less.

Additional objects and advantages of the invention will become apparent to those skilled in the art upon reference to the detailed description taken in conjunction with the provided figures.

DETAILED DESCRIPTION OF THE PREFERRED EMBODIMENTS

The afterglow of several cadmium tungstate crystals was studied by exposing the crystals individually to x-rays (120 Kev maximum) for three seconds, after which the output of the x-ray tube was interrupted. For experimental purposes, afterglow (AG) was defined as the ratio shown below in Equation 1 where $I_{DC}$ is the intensity of light emitted from a dark crystal (prior to exposure to radiation), $I_0$ is the intensity of light emitted from a crystal at the instant $t=0$ that radiation is interrupted, and $I_{(t)}$ is the intensity of light emitted from a crystal at time "t". The constant factor in the equation was used to assign "parts per million" as the unit of measurement for afterglow in terms of the total light output.

$$AG = \frac{I_{(t)} - I_{DC}}{I_0 - I_{DC}} \; x \; 10^6 \qquad\qquad (1)$$

For each crystal studied, measurements of I(t) were taken every millisecond after $t=0$ up to $t=3$ seconds. It was decided that measurements taken at $t=20$ ms (milliseconds) would be used as a comparative standard. At 20 ms, an acceptable level of afterglow is 50 ppm. In the crystals initially studied, afterglow in the range of 300 ppm-500 ppm was frequently observed. It was also observed that the spectral distribution of the afterglow emission is almost entirely at wavelengths larger than 550 nm (nanometers) and mostly larger than 650 nm. It was therefore conceived that it might be possible to optically filter the afterglow emission without substantially reducing the normal light output which peaks at about 480 nm.

After several experiments in which crystals were coated with filtering layers and unsuitable results were obtained, it was conceived that doping the crystal melt with a red-absorbing impurity might operate to absorb afterglow. Several boules were grown from a melt doped with cobalt and compared to boules grown from the same raw materials. The cobalt doped crystals are discussed in Examples 1 through 4, below.

Example 1

A reference boule was grown for use as a control boule from a first batch of cadmium tungstate raw material with no added dopant. The scintillation light output of this reference boule when subjected to reference x-ray radiation of 120 Kev (thousand electron volts) intensity was for convenience defined to be 100%. The afterglow was measured to be 155 ppm of the light output.

A first doped boule was grown from the same raw material as was the first, reference boule, but the melt was doped with 50 ppm of cobalt. The light output of this material when subjected to the reference radiation was 76% of that of the undoped reference boule. The afterglow was quite low and uniform, having an average afterglow was 42 ppm, with a range of from 36 ppm to 44 ppm. The crystal had a deep blue color due to a red absorption centered at about 630 nm and the peak output wavelength was shifted 15 nm toward the blue from that of the undoped reference boule. The crystal was installed in a sensor array and was tested for afterglow effects on imaging. It worked very well with regard to afterglow, but its light output was judged to be below the acceptable level for some applications.

Example 2

Another reference boule was grown from a new batch of raw material. Its light output was measured and defined as 100%. The afterglow was measured to be 155 ppm. A doped boule was grown from this raw material with the melt doped with 25 ppm of cobalt. The light output of the cobalt-doped boule was measured to be 92 % of that of the reference boule, and its aberage afterglow was measured to be 39 ppm.

Example 3

A third boule was grown with only 10 ppm of cobalt in the melt. It had low afterglow, an average of 38 ppm, with a range of 26 ppm to 59 ppm. The light output was 102% of an undoped boule grown from the same batch of raw material. This can be taken to mean that within the limits of error of the light output reading, there was no measurable light loss.

Example 4

Three cobalt-doped boules were grown in standard production furnaces. The melts contained 25 ppm of cobalt. The average afterglow of the three boules was 40 ppm, and the range was 32 ppm to 55 ppm. Their average light output was 96% of the average of four other undoped reference boules grown from the same raw material batch and measured at the same time.

GENERAL CONSIDERATIONS

Cobalt-doped cadmium tungstate boules appear to have a broad band absorption in the wavelength region between 540 nm and 700 nm. Cobalt-doped boules also have less light output than undoped boules from the same raw material. Reducing the amount of cobalt in the cadmium tungstate reduces the amount of light it absorbs and thereby increases its light output. By adjusting the amount of cobalt, it is possible to have a crystal with light output in the excess of 90% of the light output of an undoped crystal and an afterglow that is reduced by a factor of five or more. Although the concentration of cobalt in the melt was varied between 10 ppm and 50 ppm, the actual concentration of cobalt in the doped crystals was much smaller due to the natural tendency of the crystal lattice to reject impurities during growth. Three exemplary boules are listed in Table 1 below in which the cobalt concentration in the boule is related to the concentration in the melt.

Table 1

| Boule Number | Melt Doping Level of Cobalt in PPM | Cobalt Concentration in the Boule in PPM | 2d Test of Cobalt Concentration in the Boule in PPM |
|---|---|---|---|
| 5-035 | 50 | Cone 0.7 Heel 3.2 | Cone 1.3 Heel 5.0 |
| 5-049 | 25 | Cone 0.9 Heel 1.5 | Cone 1.0 Heel 1.2 |
| 6-047 | 10 | Cone 1.3 Heel 1.8 | Cone 1.1 Heel 2.1 |

A pure cadmium tungstate crystal has an index of refraction of about 2.2 in the wavelength range of emission, and it is totally transparent in this range. When used as a radiation detector, it is generally used in some form of a right rectangular solid. The high degree of symmetry provided by the solid, coupled with its high index and transparency, means that the photons of light generated inside the crystal by the absorption of an x-ray photon will have a very long average optical path inside the crystal before escaping into the detector. This enables even a very slight absorption in the wavelength range of emission to have a profound effect on the spectral distribution of the light output. Thus, by putting a red absorber inside the crystal's lattice, the afterglow component of the light output may be selectively and effectively removed from the overall light output.

While the experiments with cobalt suggest that the cobalt dopant acts as an optical absorption filter to remove the relatively long wavelength spectral components of afterglow, the cobalt dopant may indeed act to quench the afterglow by inactivating its source. Since the precise mechanism responsible for afterglow is as yet unclear, it has not been definitely determined whether cobalt acts primarily as a filter, a quencher, or both.

In addition to the above-described experiments with cobalt, other dopants were used in cadmium tungstate melts to identify other materials which might be candidates for afterglow-reducing dopants. For each raw material batch an undoped crystal was first grown as a reference boule and by exposure to the reference radiation source was tested for light output, defined as 100%, and for afterglow. The same raw material batch was then used to grow a series of other crystals which were doped with different impurities as listed in the tables below by adding 50 ppm of the dopant to the melt, unless otherwise indicated. Several of the dopants listed in the tables would not appear to be acting as an optical absorber, but rather as an afterglow quencher.

The light output and afterglow of material of boules grown from the first batch of raw material are listed in the table 2 below.

| dopant | %light output | ppm afterglow |
|---|---|---|
| none | 100 | 42 |
| tantalum | 81 | 82 |
| niobium | 67 | 21 |
| bismuth | 77 | 8240 |
| nickel | 86 | 133 |
| cobalt | 76 | 42 |
| germanium | 94 | 44 |
| bismuth germanium oxide | 40 | 287 |
| magnesium | 78 | 214 |

Table 2

Another cadmium tungstate reference boule was grown from a secondbatch of raw material and its light output when irradiated by the reference radiation source was defined as 100%. Seven additional boules were grown, each with a different one of various dopants which were included in the melt at a concentration of 50 ppm, except as otherwise indicated. Their characteristics are listed below in table 3.

| dopant | % light output | ppm afterglow |
|---|---|---|
| none | 100 | 155 |
| copper | 68 | 91 |
| sodium | 88 | 40 |
| calcium | 98 | 48 |
| chromic oxide ($Cr_2O_3$) | 67 | 53 |
| molybdenum | 75 | 313 |
| chromous oxide (CrO) | 52 | 25 |
| cobalt (25 ppm) | 92 | 39 |

Table 3

Another cadmium tungstate reference boule was grown from a third batch of raw material and its light output when irradiated by the set radiation intensity was defined as 100%. Five additional boules were grown, each with a different one of various dopants which were included in the melt at a concentration of 50 ppm, except as othewise indicated. In the case of the dopant bromine, iodine, and phosporus, 25 ppm of each of the three dopants was added to the melt. The characteristics of the resulting boules are listed below in table 4.

Table 4

| dopant | % light output | ppm afterglow |
|---|---|---|
| none | 100 | 91 |
| neodymium | 14 | 53 |
| iron | 48 | 76 |
| cobalt (10 ppm) | 102 | 38 |
| bromine/iodine/phosphorus (25 ppm of each) | 108 | 49 |
| thallium | 109 | 120 |

The three light output values over 100% are thought to be a result of measurement inaccuracies. It should be noted that the afterglow measurements listed in tables 3 amd 4 were obtained by measurements on cleaved slabs of material, while those listed in table 2 were obtained by measurements on finished sticks of material. Because slabs are simply cleaved from the boule and are therefore not as precisely dimensioned and surface finished as are completed crystal rods, the afterglow measurement from slabs are generally substantially higher than those of the same material made from finished crystal rods and are also considerably less consistent. Therefore, the values of table 2, which were obtained from measurements on finished crystal rods should not be compared with those of tables 3 and 4. Furthermore, it should be recognized that only limited comparison information is available from any measurement comparisons between materials of boules made from different batches of raw material. Nevertheless, the values of tables 3 and 4 can be used to obtain a rough indication of the relative afterglow values for the matrials measured. Thus it would seem from tables 3 and 4 that that calcium, cobalt, germanium, niobium, sodium, and chromium are particularly good additional candidates for reducing afterglow in cadmium tungstate, with neodymium also being of interest. It could be said that any dopant which reduces the afterglow to less than about 50 ppm is likely to be of interest for the purpose of controlling afterglow. There may be additional candidates which are not among those dopants included in the above tests. These can be expected to be known activator substances for scintillation crystals and would typically be either transition metals or rare earth elements.

There have been described and illustrated herein several embodiments of a cadmium tungstate scintillation crystal having reduced afterglow, as well as several methods of making the same. While particular embodiments of the invention have been described, it is not intended that the invention be limited thereto, as it is intended that the invention be as broad in scope as the art will allow and that the specification be read likewise. Thus, while particular effective dopants have been disclosed, it is contemplated that other dopants may be useful in either absorbing or quenching afterglow. Although it is uncertain how the dopants act to reduce afterglow, it is certain that some dopants significantly reduce afterglow when used in the proper concentrations. Also, while cadmium tungstate crystals have been discussed, it is believed that the doping methods of the invention may be useful in reducing afterglow in other types of scintillation crystals. The concentration of such afterglow-reducing dopants in the crystal should generally be chosen to be no higher than necessary to provide the desired afterglow reduction, since additional concentrations are likely to reduce the light output of the crystal. The precise amount of the dopant is expected for most crystals to be less than the concentration which results from the addition of 50 ppm of dopant to the melt, but is best found for a particular crystal and dopant by empirical methods such as in the above examples. Although in the examples herein the dopant was introduced into the crystal by addition of the dopant material to the melt, it should be understood that the invention is not limited to a particular crystal growth method or a particular crystal material, but relates to the addition by any method of any afterglow-reducing dopant in any concentration to any scintillation crystal made by any method.

**Claims**

1. A method of making a scintillation crystal, comprising:

    a) preparing a crystal melt;
    b) adding an afterglow-reducing dopant to the melt prior to growing the crystal;

c) growing the crystal such that it contains a relatively low concentration of the afterglow-reducing dopant.

2. A method according to claim 1, wherein:
the afterglow-reducing dopant is selected from the group consisting of calcium, cobalt, germanium, niobium, sodium, and chromium

3. A method according to claim 2, wherein:
the afterglow-reducing dopant is cobalt, which is added to the melt at a concentration of less than about 50 ppm.

4. A method according to claim 3, wherein:
the afterglow-reducing dopant is added to the melt at a concentration of between about 1 ppm and about 50 ppm.

5. A method according to claim 3, wherein:
the crystal is grown such that it contains a cobalt concentration of less than about to 5 ppm.

6. A method according to claim 5, wherein:
the crystal is grown such that it contains a cobalt concentration of between about 1 ppm and about 5 ppm.

7. A method according to claim 1, wherein:
the crystal is cadmium tungstate.

8. A method according to claim 7, wherein:
the afterglow-reducing dopant is selected from the group consisting of calcium, cobalt, germanium, niobium, sodium, and chromium.

9. A method according to claim 8, wherein:
the afterglow-reducing dopant is cobalt which is added to the melt at a concentration of less than about 50 ppm.

10. A method according to claim 9, wherein:
the crystal is grown such that it contains a cobalt concentration of less than about 5 ppm.

11. A method according to claim 1, wherein:
said preparing a crystal melt is according to the Czochralsky technique.

12. A scintillation crystal comprising:
a scintillator crystal lattice doped with an afterglow-reducing dopant.

13. A scintillation crystal according to claim 12, wherein:
said afterglow-reducing dopant is selected from the group consisting of calcium, cobalt, germanium, niobium, sodium, and chromium.

14. A scintillation crystal according to claim 13, wherein:
said afterglow-reducing dopant is cobalt in a concentration of less than about 5 ppm.

15. A scintillation crystal according to claim 14, wherein:
said afterglow-reducing dopant is cobalt in a concentration of between about 1 ppm and about 5 ppm.

16. A scintillation crystal according to claim 15, wherein:
said scintillator crystal lattice is cadmium tungstate.

17. A scintillation crystal according to claim 16, wherein:
said afterglow-reducing dopant is selected from the group consisting of calcium, cobalt, germanium, niobium, sodium, and chromium.

18. A scintillation crystal according to claim 17, wherein:

said afterglow-reducing dopant is cobalt in a concentration of less than about 5ppm.

**European Patent Office**

# EUROPEAN SEARCH REPORT

Application Number

EP 97 20 0411

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | EP 0 467 044 A (GEN ELECTRIC) 22 January 1992<br>* page 4, line 50 - page 6, line 11 *<br>* page 7, line 54 - page 8, line 7; claim 1 *<br>--- | 1,11,12 | C30B15/00 |
| X | JOURNAL OF CRYSTAL GROWTH,<br>vol. 52, 1 April 1981, AMSTERDAM,<br>pages 580-583, XP002032066<br>K.TAKAGI ET AL.: "Growth of high purity ZnWO4 single crystals"<br>* the whole document *<br>--- | 1,2,<br>11-13 | |
| X | DE 15 44 239 A (N.V.PHILIPS' GLOEILAMPENFABRIEKEN ) 9 April 1970<br>* examples 1-3 *<br>--- | 1,2,<br>11-13 | |
| X | GB 2 045 795 A (HITACHI LTD) 5 November 1980<br>* page 3, line 46; example 1 *<br>--- | 1,2,<br>11-13 | |
| A | APPLIED PHYSICS LETTERS,<br>vol. 36, no. 4, 1 February 1980, NEW YORK,<br>pages 278-279, XP002032067<br>T.OI ET AL.: "Scintillation study of ZnWO4 single crystals"<br>* the whole document *<br>----- | 1-18 | TECHNICAL FIELDS SEARCHED (Int.Cl.6)<br><br>C30B |

The present search report has been drawn up for all claims

| Place of search | Date of completion of the search | Examiner |
|---|---|---|
| THE HAGUE | 2 June 1997 | Flink, E |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)